Europäisches Patentamt

European Patent Office

Office européen des brevets

⑩

(11) Publication number: **0 182 876**
**B1**

(12) **EUROPEAN PATENT SPECIFICATION**

(45) Date of publication of patent specification: 24.10.90

(21) Application number: 85902890.4

(22) Date of filing: 22.05.85

(86) International application number:
PCT/US85/00990

(87) International publication number:
WO 85/05736 19.12.85 Gazette 85/27

(51) Int. Cl.⁵: **H 01 L 27/02**

(54) TRI-WELL CMOS TECHNOLOGY.

(30) Priority: 25.05.84 US 614418

(43) Date of publication of application:
04.06.86 Bulletin 86/23

(45) Publication of the grant of the patent:
24.10.90 Bulletin 90/43

(84) Designated Contracting States:
DE FR GB NL SE

(56) References cited:
EP-A-0 085 168
EP-A-0 091 256
EP-A-0 091 256
US-A-4 435 896

PATENTS ABSTRACTS OF JAPAN, vol. 7, no.
251 (E-209)1396r, 8th November 1983; & JP - A -
58 138 068 (TOKYO SHIBAURA DENKI K.K.)
16-08-1983

NEUES AUS DER TECHNIK, no. 1/2, 15th April
1983, page 1, Würzburg, DE; "Verfahren zur
Bildung einer CMOST-Struktur"

(73) Proprietor: **AMERICAN MICROSYSTEMS,
INCORPORATED**
2300 Buckskin Road
Pocatello, ID 83201 (US)

(72) Inventor: **JOY, Richard, C.**
103 Cherry Hill Court
Los Gatos, CA 95030 (US)
Inventor: **BATRA, Tarsaim, Lal**
10306 Virginia Swan Place
Cupertino, CA 95104 (US)

(74) Representative: **Noz, Franciscus Xaverius, Ir.**
et al
Boschdijk 155
NL-5612 HB Eindhoven (NL)

## Description

### Background of the invention

This invention relates to a method of manufacturing wells in a semiconductor substrate which provides at lesat three kinds of active regions for device formation. The active regions may include lightly doped regions of either N or P type for the formation of devices having a high breakdown voltage, moderately to heavily doped P wells for N channel devices having a low breakdown voltage, and moderately to heavily doped N well regions for P channel devices having a low breakdown voltage. A tri- well cross device can be realized in such a structure.

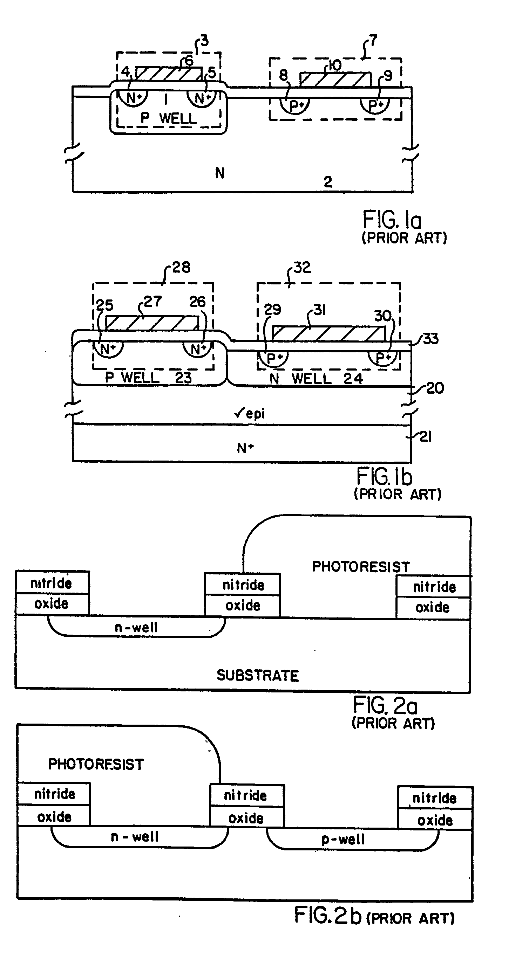

A prior art P well CMOS structure is illustrated in Figure 1a. P well 1 is diffused into a silicon substrate 2. Silicon substrate 2 has been moderately doped with N type dopants to a level within the range of approximately $2 \times 10^{15}$ to $4 \times 10^{15}$ atoms/cm³. Source and drain regions 4 and 5 respectively of an N channel device 3 having a gate 6 are then formed in P well 1, and source and drain regions 8 and 9 of a P channel device 7 having a gate 10 are formed in N type substrate 2.

In practice, due to processing variations, there is some deviation between the actual doping levels achieved in the P well and the N substrate and their desired doping levels. For control purposes, in order to render these deviations less significant, the doping of P well 1 is at least an order of magnitude greater than the doping of N substrate 2, thereby insuring that, regardless of processing variations, P well 1 will have a sufficiently high concentration of P type dopants.

Problems of scale emerged from the prior art structure as the device density, i.e., the number of devices per unit area, was increased. For example, as the distance between the P+ source and drain regions 8 and 9 of device 7 is reduced, the doping of N substrate 2 must increase to obtain appropriate electrical parameters, such as device threshold voltage, in the shorter channel length P channel transistor 7. However, increasing the doping of N substrate 2 requires a corresponding proportional increase in the doping level of P well 1 for control purposes as explained above.

The increase in the doping level of P well 1 causes increases junction capacitance between N+ source and a drain regions 4 and 5 and P well 1. In fact, for a single-sided junction under zero bias, the junction capacitance varies directly as the square root of the dopant concentration on the lightly doped side of the junction, as shown in MOS Integrated Circuits, pgs. 45 and 46, Engineering Staff of American Micro-Systems, Robert E. Krieger Pub. Co., Malibu, Fla. (1979), which is incorporated herein by reference. In turn this increased capacitance has the undesirable effect of reducing the switching speed of transistor 3.

In order to overcome these problems of scale, a twin-tub CMOS technology was developed by Parrillo, et al., in "Twin-Tub CMOS-A Technology for VLSI Circuits", IEEE Tech. Dig., Int. Electron Device Meet., 1980, p 752—755 which is incorporated herein by reference. Figure 1b illustrates the Parillo Twin-tub structure.

The Parillo structure includes lightly doped epitaxial region 20 formed on an N+ substrate 21. The use of an N+ substrate reduces the substrate resistance and prevents "latch-up", a term which refers to the turning on of "parasitic" bipolar transistors within the structure shown in Figure 1b as will be explained later.

Both a P well 23 and an N well 24 are then formed in the epitaxial layer 20 by ion implantation. This is accomplished in a self-aligned manner by first defining an oxide-nitride mask (not shown), implanting and selectively oxiding N well 24, removing the remaining mask and implanting P well 23 self-aligned to the oxide masked N well 24.

The P well 23 and N well 24 are doped independently in order to optimize the performance characteristics the active devices formed in P well 23 and N well 24, respectively. For example, the active devices may include transistor 28 having gate 27, gate dielectric layer 33 and source and drain regions 25 and 26, respectively, formed in P well 23 and transistor 32 having gate 31, gate dielectric layer 33, and source and drain regions 29 and 30 formed in N well 24. Thus it can be seen that increasing the doping of N well 24 to accommodate a decrease in the dimensional parameters of the P channel device 32 no longer necessitates a corresponding increase in the dopant concentration of P well 23. Of importance, parasitic bipolar transistors exist within this twin well structure. For example, an NPN parasitic transistor is formed by N+ region 26, P well 23, and N+ substrate 21. Howsever, the N+ substrate has low resistivity and thus prevents "latch-up". Latch-up is a well-known problem, an analysis of which is presented in an article entitled "Elimination of Latch-up in Bulk CMOS", IEDM Paper 10.2, December 8—10, Washington, D.C., which is incorporated herein by reference.

Both N well 24 and P well 23 in the prior art twin-tub structure described by Parillo are heavily doped. Parillo uses a dopant concentration of about $10^{16}$ atoms/cm³ at the surface of each well. Because of the relatively high doping in both wells, this structure is not well suited to integration with devices such as transistors, diodes, or resistors which are designed to operate at high voltages, say greater than 20 volts. In particular the prior art twin-tub structure is not suited for the integration of erasable programmable read only memories (EPROMS) or with electrically erasable programmable read only memories (EEPROMS) which require junction breakdown voltages greater than approximately 20 volts.

In addition to the need for providing both high and low voltage devices on the same chip, and thus providing a variety of doping levels for different wells, it is desirable to develop methods for forming structures which are faster and less expensive, and allow for forming smaller devices while retaining high yield. Various prior art methods have been developed to accomplish the objective of providing on the same chip different doping levels and dopants for different wells.

A method shown in Figures 2a and 2b forms multiple windows in a nitride/oxide layer, exposing the surface to permit the subsequent formation of diffusion isolation regions, base regions, and collector contact regions in the semiconductor body. The areas are masked, exposed, and doped in a predetermined sequence. The original areas of oxide/nitride, which were left between windows serve to define the edges of the wells, and on these areas of oxide/nitride the edges of successive photoresist masks are defined. Mask misalignment tolerances can be less stringent because the edges of the masks are formed over the previously formed areas of nitride/oxide and the nitride/oxide serves to define the edge of the well. U.S. Patent No. 3,928,081 to Marley, Jr. et al., shows such a method for eliminating mask misalignment tolerances.

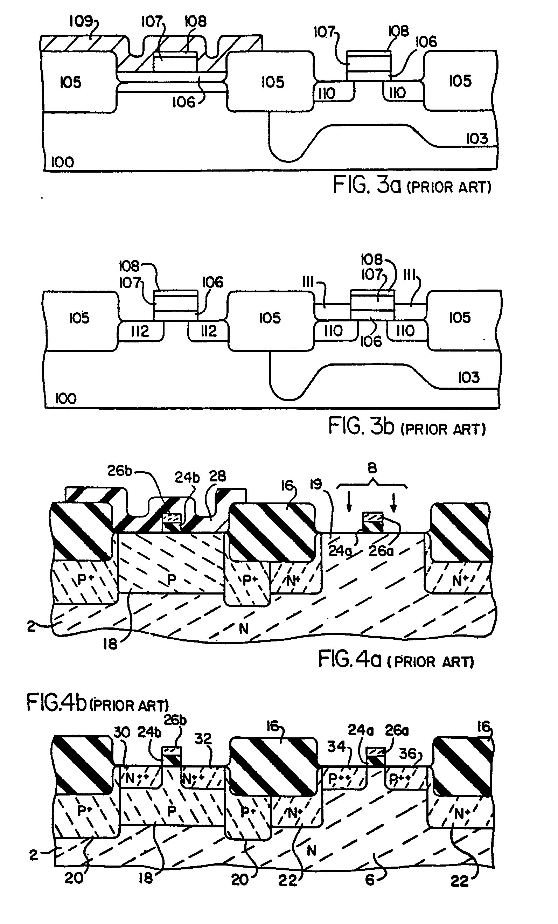

As shown in Figure 3a and 3b, U.S. Patent 4,450,021, issued to Batra, et al., one of the coinventors of this application, uses a mask 109 for defining regions 110 to be doped and uses the same mask for depositing a protective layer 111 over the doped regions. With this arrangement, the alignment of the edge of the protective layer 111 is assured, because the edge of the oxide defines the area to be doped. When the mask is removed, the second regions 112 which are now exposed are automatically aligned to be doped without interfering with the first regions which are covered by protective layer 111. By this method it is possible to achieve doping of two wells with one masking step, thus saving the time of applying and defining the mask and thus also achieving automatic self-alignment of the areas to be doped. The method shown in this prior art patent is described as being applicable to implanting source and drain regions in the chip.

Thus, use of portions of the device as a mask for forming later portions is a well-known method of preventing misalignment.

Cerofolini, et al., in U.S. Patent No. 4,277,291, discloses a different method, shown in Figures 4a and 4b which could be used for forming adjacent, self-aligned N and P wells in which a heavily N-doped oxide mask is in place during P-doping and diffusion. The N-doped oxide mask prevents doping of the masked portion during the P-doping step and then produces diffusion of the N-dopant from the doped oxide into the substrate at the same time the P-doped region is being diffused into the substrate, resulting in simultaneous formation of self-aligned N and P wells.

EP—A—0,091,256 discloses a structure having three types of well which may be of different doping levels, wherein the edges of the wells are self-aligned.

Summary
The present invention provides a method of forming a semiconductor structure having at least three active regions for device formation formed in a lightly doped substrate, for example, a first moderately to heavily doped well of the same conductivity type as the substrate, a second moderately to heavily doped well having conductivity type opposite to that of the substrate, and a third lightly doped region of either type having a conductivity of the same order of magnitude as the substrate. In one embodiment of the structure the third region is a portion of the substrate itself.

This method of forming a semiconductor structure requires fewer masking steps than the number of wells to be formed in the substrate. The method involves first defining an exposed region to be doped, then doping that region to form a well in which the field and active region of a device will be formed, then covering that region with a thick oxide layer. Using a second photoresist mask, another area of thin oxide/nitride is removed, with the newly formed thick oxide and/ or the oxide/nitride serving to define edges of the second exposed area, and so on with subsequent regions. This order of formation causes subsequent well regions to be automatically self-aligned with previous well regions and also results in a process for forming successive well regions requiring fewer masking steps than the number of wells, in contrast to previous methods. This improvement in turn results in allowing a higher yield of smaller devices at a lower manufacturing cost. The method does not require accurate alignment of a photoresist mask with a previous photoresist mask. Alternative embodiments are also described.

Brief description of the drawings
Figure 1a shows a prior art P well CMOS structure.
Figure 1b shows a prior art twin-tub CMOS structure.
Figures 2a and 2b show a prior art method of forming windows for the subsequent formation of doped wells followed in series by separate masking of subsequent wells.
Figures 3a and 3b show a prior art method of using an oxide region to define the edge of a well to be doped followed by growing an oxide or nitride mask over the doped region before removing the photoresist mask.
Figures 4a and 4b show a prior art method of growing adjacent wells using a mask of heavily-doped oxide which implants dopants of one conductivity type while dopants of opposite conductivity type are implanted into an exposed adjacent area.
Figure 5 shows a second embodiment of the tri-well CMOS structure constructed in accordance with this invention.
Figures 6a and 7a through 7h show steps in forming three wells of different composition using the method of this invention where adjacent wells are self-aligned.
Figures 7i and 7j show a device having two implanted, self-aligned wells and a third self-aligned high voltage region available for active device formation.

Figures 8 through 10 show steps of well known design used to form a device upon the substrate which was formed as shown in Figures 6a and 7a through 7h according to the method of this invention.

Detailed description

For a P-type silicon substrate, a resistivity of approximately 30 to 100 ohm-cm corresponds to an impurity concentration of approximately $1 \times 10^{14}$ to $2.5 \times 10^{14}$ P-type atoms/cm³ in the substrate. This is shown in Grove, *Physics and Technology of Semiconductor Devices*, pgs. 111—113, John Wiley & Sons (1967) which is incorporated herein by reference. In general, the resistivity of the substrate decreases as the impurity concentration in the substrate increases.

Since resistivity, ρ, is the reciprocal of conductivity, σ, (i.e., σ=1/ρ), one may equivalently specify the corresponding conductivity of the substrate.

In turn the breakdown voltage for several important classes of PN junctions is inversely proportional to the substrate impurity concentration. For example, a so-called one-sided step junction, which is an abrupt junction wherein the impurity concentration in each of the P and N regions is uniform throughout that region and wherein the concentration of the impurity on one side of the junction is much larger than on the other side of the junction, has the property that the junction breakdown voltage is inversely proportional to the substrate dopant concentration for a constant critical field as shown in *Grove*, supra, at pg. 194, which is incorporated herein by reference. Similarly, very shallow diffused junctions behave very much like one-sided step junctions. See *Grove*, supra at pg. 159.

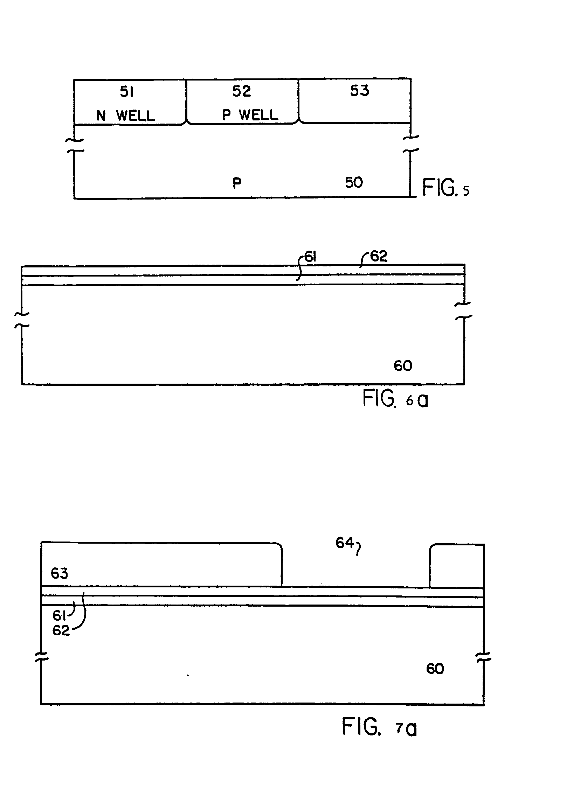

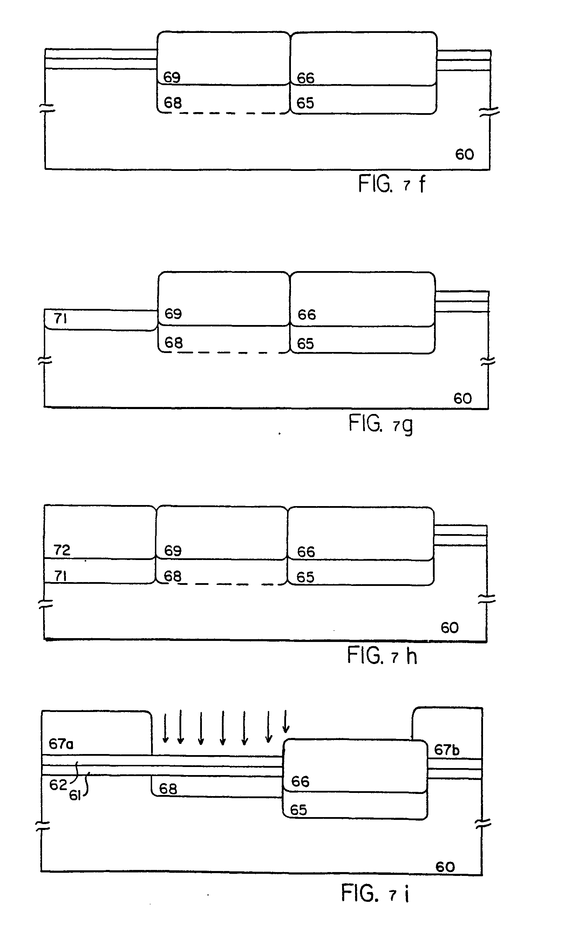

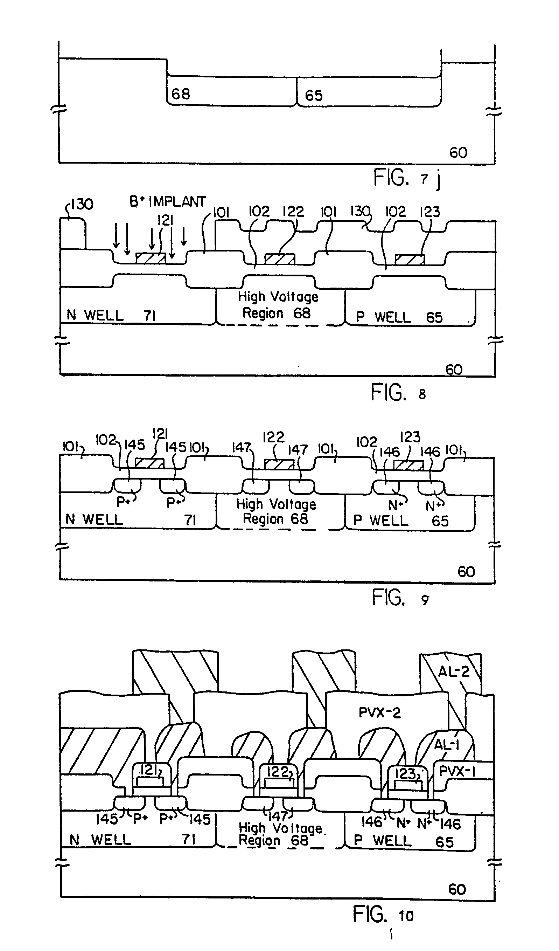

One process for forming a tri-well CMOS structure according to the present invention is illustrated in Figure 6a and Figures 7a—7h. The process begins with a lightly doped substrate 60 of either N type or P type. When substrate 60 is P type, a dopant concentration of approximately $1 \times 10^{14}$ atoms/cm³ is typical. An N type, substrate would have a lower dopant concentration.

Figure 6a shows a lightly doped semiconductor substrate with a base oxide layer and a nitride layer formed thereon. Base oxide layer 61 is formed on substrate 60 to a thickness within the range of approximately 500 to 1000Å, for example by thermal oxidation at approximately 1000°C for approximately 45 to 75 minutes in an atmosphere of $O_2$+3% HCL.

Nitride layer 62 is formed on base oxide layer 61 using, for example, low pressure cehemical vapor deposition (LPCVD) to a thickness of approximately 1500Å. Oxide 61 separates nitride 62 from substrate 60 and thus allows nitride 61 to be completely removed at a later stage.

According to one method for forming the separately implanted well regions of this invention, base oxide 61 and nitride layer 62 shown in Figure 6a are then patterned to define the active regions of the device.

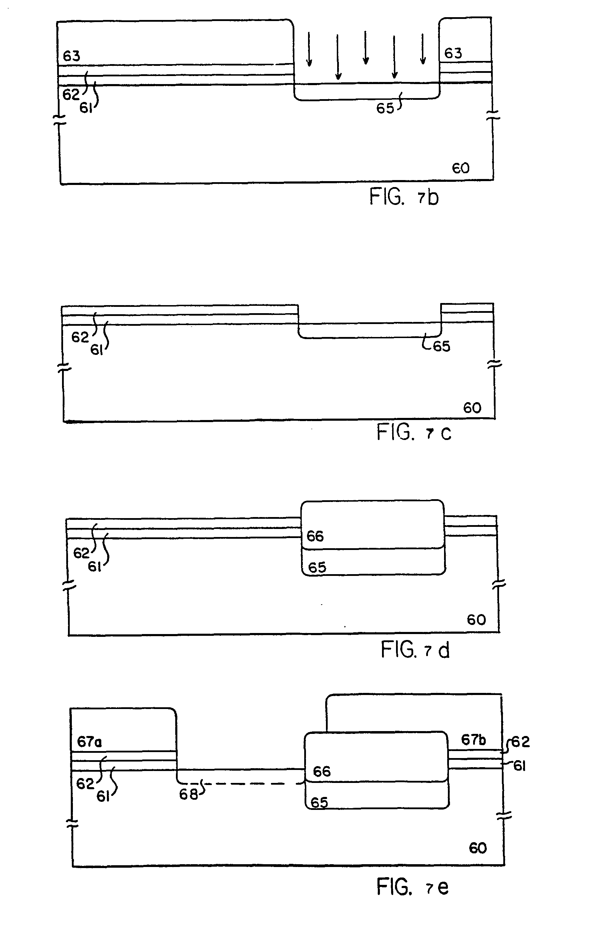

According to the method for forming the separately implanted well regions of this invention in which adjacent well ·regions are automatically self-aligned, base oxide layer 61 and nitride layer 62 shown in Figure 7a are then patterned to define one of the well regions of the device. Referring to Figure 7a, this patterning is accomplished by spinning onto nitride layer 62 photoresist 63 which is then soft baked. The first well region mask is then aligned to the wafer and the portions of photoresist exposed by the mask are subjected to actinic radiation. Exposed portions 64 of the photoresist are then removed as shown in Figure 7a. Photoresist 63 is then hard baked so that it is not affected by the etchants which will be used to remove the unmasked regions of nitride and oxide. Typically, plasma etching is then used to remove the unmasked regions of nitride, and buffered HF is used to remove the regions of oxide as shown in Figure 7b.

A P well implant 65 is performed using boron at a dosage of approximately $6 \times 10^{12}$ ions/cm² at an energy level of approximately 120 KeV.

As shown in Figure 7c, photoresist 63 is then removed.

As shown in Figure 7d, following the doping of P well 65, a layer of oxide 66 is formed on the exposed region and the dopants in P-well 65 are simultaneously slightly diffused into substrate 60 by subjecting the wafer to a oxygen atmosphere within the range of approximately 900 to 1000°C for approximately 1—3 hours, which forms oxide layer 66 to a thickness of approximately 3,000Å.

As shown in Figure 7e, after formation of oxide 66, a second layer of photoresist 67a and 67b is applied and patterned to expose the area where the second well region will be formed. The exposed portions of nitride 62 and oxide 61 are removed (in a manner such as has been previously described), exposing the area which will become a second well 68.

The formation of this second well demonstrates a significant feature of this self-aligned method. On one side, oxide layer 66 rather than the second layer of photoresist 67b serves to define the edge of the second well. Therefore, the edge of the second well 68 is perfectly aligned with the edge of the first well 65 without depending on perfect alignment of photoresist 67b. Thus, problems with prior art alignment of adjacent wells are overcome and yet the process remains simple and inexpensive.

In this embodiment, the second well is doped for forming a high voltage device. A high voltage region need not be formed when the lightly-doped substrate itself has the desired characteristics to serve as the high voltage region. However, if it is desired to adjust the dopant type or the dopant concentration in the high voltage region, exposed high voltage region 68 may be implanted using a selected impurity type as shown in Figure 7e. For example, for a P-type high voltage region, a final dopant concentration of approximately $1 \times 10^{14}$ to $4 \times 10^{14}$ atoms/cm³ is used.

As shown in Figure 7f, after implantation, as with the P well dopants, high voltage region dopants are slightly diffused and oxide 69 grown on the exposed area. The same conditions described above for growing oxide on the P well will result in fast growth of oxide on the exposed high voltage region and much slower thickening of the existing oxide above the P well. This is because oxide growth is highly nonlinear, depending on the proximity of silicon atoms and oxygen atoms to each other.

As shown in Figure 7g, oxide and nitride are then removed from the area adjacent to high voltage well 68 where N well 71 is to be formed. An N-type dopant such as phosphorus is then used to provide a low energy implant at a dosage of approximately $5 \times 10^{12}$ ions/cm$^2$ at an energy level of approximately 25 KeV. The dopants in well regions 65, 68 and 71 are now diffused to their desired junction depth of approximately 3 to 6 microns, for example by heating the wafer in a dry oxygen atmosphere at approximately 1150°C for approximately 8 to 12 hours, thus forming oxide 72 to a thickness of approximately 1000Å.

Alternatively, if desired, portions of oxide 61 and nitride 62 need not be removed from the area adjacent to high voltage well 68 where N well 71 is to be formed. In this event, an N type dopant such as phosphorous is used to provide an implant through oxide 61 and nitride 62 covering to be formed N well 71. At this time, thick oxide layers 66 and 69 serve as a mask. After implantation, the device is heated in order to diffuse the dopants to form N well 71 as shown in Figure 7h. Since nitride layer 62 remains, thick oxide layer 72 shown in Figure 7h is not formed above N well region 71. Using appropriate and well known techniques, nitride layer 62 and oxide layers 61, 69 and 66 are then removed, and further processing as described below provides the structure shown in Figure 8.

Note that three types of wells have thus been formed using only two photoresist masks 63 and 67a, b, and that it was not necessary to align the edge of one photoresist mask with the edge of a previous mask. Thus, a simpler manufacturing process with automatic self-alignment has been achieved.

Optionally, oxide 72 may be grown to diffuse well 71 to the depth of wells 68 and 65. Oxide layers 66, 69 and 72 are then removed, leaving a tri-well substrate for device formation having good planarity and sharply defined well regions.

Figure 7h shows the semiconductor structure after oxidation, leaving N well 71, high voltage region 68 and P well 65 formed in the substrate. The dotted line around the high voltage region 68 in Figure 7h indicates that this region may be the substrate itself if no high voltage region implant is employed. Oxide layers 66, 69 and 72 are then removed using, for example, buffered HF, and devices are formed in well regions 65, 68 and 71 in a well-known manner.

An alternative embodiment shown in Figure 7j provides a structure having two implanted and diffused wells 65, 68, and which uses substrate 60 as the high voltage region without requiring an implant in the high voltage region. In this alternative embodiment, after forming oxide layer 66 as shown in Figure 7d, and applying photoresist 67a, 67b, as shown in Figure 7e, implantation is then performed through oxide/nitride layers 61 and 62 to form implanted well region 68 as shown in Figure 7i. Well 68 is automatically selfaligned with well 65. Subsequent heating to a temperature of approximately 1,150°C for approximately 8 to 12 hours diffuses implanted well 68. The layers of nitride 62, thick oxide 66 and thin oxide 61 are then removed to produce the substrate of Figure 7j having three regions for forming active devices: implanted well 65, implanted well 68, and substrate region 60 which is appropriate for high voltage devices.

As will also be appreciated by those who are skilled in the art in light of the teachings of this invention, it is also possible to implant well region 68 by first removing nitride layer 62. In this event, during the diffusion of implanted dopants in well region 68, an additional thick oxide layer is formed over N well 68. This thick oxide is then simultaneously removed with the removal of thick oxide layer 66.

Device formed using this invention

Regardless of which embodiment is used, oxides formed over well regions and the substrate itself are removed, as is any remaining nitride. A new base oxide layer (200 to 500Å thick) and a layer of nitride (1500Å) is formed thereon. An active area mask, which defines the active regions, is used followed by field implantation and the formation of field oxide (typically 10,000Å thick), as is known in the art. The initial base oxide/nitride layer is removed, and a gate dielectric is formed.

Figures 8—10 show formation of a portion of a typical circuit using the tri-well substrate just described after formation by any of the method embodiments which have been described in detail. Thick oxide 101 is formed at the boundaries between one well and the next to prevent formation of parasitic current paths between one active device and the next. A thinner portion of oxide 102 for insulation purpose is formed over the centers of each well region.

A polycrystalline silicon layer is then deposited as described earlier and gates 121, 122 and 123 for active devices in N well 71, high voltage region 68, and P well 65 and doped polycrystalline silicon interconnects (not shown) are then formed.

Source and drain regions 145 (shown in Figure 9) are formed in N well 71 by forming a P type source/drain mask 130 (shown in Figure 8) of photoresist which exposes the regions where P type boron ions are to be implanted to form source/drain regions. The boron implant is performed using a dosage of $3 \times 10^{15}$ ions/cm$^2$ at an energy level of approximately 50 KeV. If the high voltage region 68 is also N-type, boron mask 130 also exposes the high voltage region.

Similarly, N+ source and drain regions are formed in P well 65 by forming an N+ source/drain mask of photoresist (not shown) which exposes the regions where N+ type ions are to be implanted. The N+ implant can be performed using a dosage of approximately $5 \times 10^{15}$ phosphorous ions/cm$^2$ at an energy level of approximately 75 KeV. If the high voltage region 68 is also P type, the N+ source/drain implant for the high voltage region 68 is accomplished at the same time that the N+ source/drain regions are formed in P well 65.

After the source and drain implants, the wafer is subjected to an O$_2$ ambient at approximately 900°C to 1000°C to achieve appropriate junction depth of approximatley 0.3 microns. During this process approximately 500Å of oxide is grown on the source/drain regions. The resulting semiconductor structure shown in Figure 8, has P+N well source and drain regions 145, N+P well source and drain regions 146 and source and drain regions 147 of a selected conductivity type in high voltage region 68.

Standard processing techniques are employed to complete the formation of active devices on regions 65, 68 and 71 to produce a device such as shown in Figure 9, with first metal contact layer AL-1, second metal layer Al-2, first PVX layer PVX-1 and second PVX layer PVX-2.

The above embodiments are intended to be exemplary and not limiting, and in view of the above disclosure, many substitutions and modifications will be obvious to one of average skill in the art without departing from the scope of the invention as defined in the claims. As but one example, as will be readily recognized by one of ordinary skill in the art in light of the teachings of this invention, the well regions can be formed first, and the field implants formed thereafter. As another example, it would of course be possible to form more than three regions, providing, for one example, two high voltage regions of opposite conductivity type. As yet another example, the second well can be formed not adjacent to the first well, photoresist serving to mark both boundaries of the second well. After forming of thick oxide on this second well, thick oxide over the first and second wells then defines both boundaries of a third well.

**Claims**

1. A method of forming wells (65, 68, 71) in a semi-conductor substrate (60) comprising:
   depositing a thin layer of oxide (61) on said substrate (60),
   depositing a layer of silicon nitride (62) on said thin layer of oxide (61),
   initiating a process to be repeated at least two times of:
   applying a layer of photoresist (63),
   removing portions (64) of said photoresist (63), thereby exposing portions of said silicon nitride (62),
   removing exposed portions of said silicon nitride (62) and thin oxide (61), thus creating exposed portions of said semiconductor substrate (60),
   implanting dopants of a selected conductivity type to a selected concentration into said exposed portions of said semiconductor substrate (60), thereby forming a well (65) of said selected conductivity type having a breakdown voltage determined by said selected concentration, and
   oxidizing said exposed portions of said semiconductor substrate (60) thus creating protective thick oxide (66) over said exposed portions and diffusing said dopants into said semiconductor substrate (60), said thick oxide (66) serving as a mask during subsequent repetitions of said process and causing subsequent wells (68, 71) to be self aligned with wells (65, 68) beneath said thick oxide (66, 69);
   and after sufficient repetition of said process, removing said protective thick oxide (66, 69, 72).

2. A method for forming wells (65, 68, 71) in a semiconductor substrate (60) as in Claim 1, wherein said process to be repeated at least two times is repeated three times.

3. A method for forming wells (65, 68, 71) in a semi-conductor substrate (60) as in Claim 1, wherein said first conductivity type is N and said second conductivity type is P.

4. A method for forming wells (65, 68, 71) in a semi-conductor substrate (60) as in Claim 1, wherein said first conductivity type is P and said second conductivity type is N.

5. A method for forming wells (65, 68, 71) in a semiconductor substrate (60) as in Claim 3, wherein said dopants of said first conductivity type are phosphorous and said dopants of said second conductivity type are boron.

6. A method for forming wells (65, 68, 71) in a semiconductor substrate (60) as in Claim 4, wherein said dopants of said first conductivity type are boron and said dopants of said second conductivity type are phosphorous.

7. A method of forming wells (65, 68, 71) in a semiconductor substrate (60) as in Claim 1, comprising the further steps of when one well (68, 71) region remains to be formed,
   applying a layer of photoresist (67a, b),
   removing portions of said photoresist (67a, b), thereby creating exposed portions of said silicon nitride (62),
   implanting through said exposed portions of silicon nitride (62) and said thin layer of oxide (61) dopants of a selected conductivity type to a selected concentration into said semiconductor substrate (60), thereby forming a well (68, 71) of said selected conductivity type having a breakdown voltage determined by said selected concentration,
   diffusing said dopants of a selected conductivity type into said semiconductor substrate (60), and
   removing said layer of silicon nitride (62) and said thin layer of oxide (61).

## Patentansprüche

1. Verfahren zur Bildung von eingelassenen Zonen (65, 68, 71) in einem Halbleitersubstrat (60), mit folgenden Schritten:

Aufbringen einer dünnen Oxidschicht (61) auf das Substrat (60),

Aufbringen einer Schicht Siliziumnitrid (62) auf der dünnen Oxidschicht (61),

Einleiten eines wenigstens zweimal zu wiederholenden Prozesses mit:

Auftragen einer Schicht Photoresist (63),

Entfernen von Teilen (64) des Photoresists (63), und dadurch Freilegen von Teilen des Siliziumnitrids (62),

Entfernen der freiliegenden Teile des Siliziumnitrids (62) und des dünnen Oxids (62), und somit Erzeugung von freiliegenden Teilen des Halbleitersubstrats (60),

Implantieren von Dotierstoffen eines ausgewählten Leitungstyps in ausgewählter Konzentration in die freigelegten Teile des Halbleitersubstrats (60), und dadurch Bildung einer eingelassenen Zone (65) des ausgewählten Leitungstyps mit einer Durchbruchspannung, welche durch die ausgewählte Konzentration bestimmt wird,

Oxidieren der freigelegten Teile des Halbleitersubstrats (60), und damit Erzeugen eines schützenden dicken Oxids (66) über den fregelegten Teilen und Diffusion der Dotierstoffe in das Halbleitersubstrat (60), wobei das dicke Oxid (66) während anschließender Wiederholungen dieses Prozesses als eine Maske dient und bewirkt, daß nachfolgende Zonen (68, 71) sich selbsttätig nach den eingelassenen Zonen (65, 68) unter den dicken Oxiden (66, 69) ausrichten,

und, nach genügender Wiederholung dieses Prozesses, Entfernen der schützenden dicken Oxide (66, 69, 72).

2. Verfahren zur Bildung von Zonen (65, 68, 71) in einem Halbleitersubstrat (60) wie in Anspruch 1, wobei der wenigstens zweimal zu wiederholende Prozeß dreimal wiederholt wird.

3. Verfahren zur Bildung von Zonen (65, 68, 71) in einem Halbleitersubstrat (60) wie in Anspruch 1, worin der erste Leitungstyp N und der zweite Leitungstyp P ist.

4. Verfahren zur Bildung von Zonen (65, 68, 71) in einem Halbleitersubstrat (60) wie in Anspruch 1, worin der erste Leitungstyp P und der zweite Leitungstyp N ist.

5. Verfahren zur Bildung von Zonen (65, 68, 71) in einem Halbleitersubstrat (60) wie in Anspruch 3, worin die Dotierstoffe des ersten Leitungstyps Phosphor und die Dotierstoffe des zweiten Leitungstyps Bor enthalten.

6. Verfahren zur Bildung von Zonen (65, 68, 71) in einem Halbleitersubstrat (60) wie in Anspruch 4, worin die Dotierstoffe des ersten Leitungstyps Bor und die Dotierstoffe des zweiten Leitungstyps Phosphor enthalten.

7. Verfahren zur Bildung von eingelassenen Zonen (65, 68, 71) in einem Halbleitersubstrat (60) wie in Anspruch 1, welches die weiteren Schritte aufweist, wenn ein eingelassenes Zonengebiet (68, 71) zur Bildung übrig bleibt:

Auftragen eines Schicht Photoresist (67a, b),

Entfernen von Teilen des Photoresists (67a, b), und dadurch Bilden von freiliegenden Teilen es Siliziumnitrids (62),

durch die freigelegten Teile des Siliziumnitrids (62) und der dünnen Oxidschicht (61) Implantieren von Dotierstoffen eines ausgewählten Leitungstyps in einer ausgewählten Konzentration in das Halbleitersubstrat (60), und dadurch Bildung einer Zone (68, 71) des ausgewählten Leitungstyps mit einer Durchbruchspannung, welche durch die ausgewählte Konzentration bestimmt wird,

Diffusion der Dotierstoffe eines ausgewählten Leitungstyps in das Halbleitersubstrat (60), und

Entfernen der Schicht Siliziumnitrid (62) und der dünnen Oxidschicht (61).

## Revendications

1. Procédé de formation de puits (65, 68, 71) dans un substrat semi-conducteur (60) comprenant:

le dépôt d'une mince couche d'oxyde (61) sur ledit substrat (60),

le dépôt d'une couche de ntirure de silicium (62) sur ladite mince couche d'oxyde (61),

l'amorçage d'un processus qui doit être répété au moins deux fois et qui consiste à:

appliquer une couche de résine photosensible (63),

retirer des parties (64) de ladite résine photosensible (63), pour exposer ainsi des parties dudit nitrure de silicium (62)

retirer les parties exposées dudit nitrure de silicium (62) et dudit oxyde mince (61), pour créer ainsi des parties exposées dudit substrat semi-conducteur (60),

implanter des dopants d'un type de conductivité choisi en une concentration choisie dans lesdites parties exposées dudit substrat semi-conducteur (60), pour former ainsi un puits (65) dudit type de conductivité choisi ayant une tension de claquage déterminée par ladite concentration choisie,

oxyder lesdites parties exposées dudit substrat semiconducteur (60) pour créer ainsi un oxyde protecteur épais (66) au-dessus desdites parties exposées et diffuser lesdits dopants dans ledit substrat semi-conducteur (60), ledit oxyde épais (66) servant de masque au cours des répétitions ultérieures dudit processus et amenant lesdits puits (68, 71) ultérieurs à être auto-alignés avec les puits (65, 68) au-dessous dudit oxyde épais (66, 69);

et après une répétition suffisante dudit processus, à retirer ledit oxyde protecteur épais (66, 69, 72).

2. Procédé pour former des puits (65, 68, 71) dans un substrat semi-conducteur (60) selon la revendication 1, dans lequel ledit processus qui doit être répété au moins deux fois est répété trois fois.

3. Procédé pour former des puits (65, 68, 71) dans un substrat semi-conducteur (60) selon la revendication 1, dans lequel ledit premier type de conductivité est N et ledit second type de conductivité est P.

4. Procédé pour former des puits (65, 68, 71) dans un substrat semi-conducteur (60) selon la revendication 1, dans lequel ledit premier type de conductivité est P et ledit second type de conductivité est N.

5. Procédé pour former des puits (65, 68, 71) dans un substrat semi-conducteur (60) selon la revendication 3, dans lequel lesdits dopants dudit premier type de conductivité sont du phosphore et lesdits dopants dudit second type de conductivité sont du bore.

6. Procédé pour former des puits (65, 68, 71) dans un substrat semi-conducteur (60) selon la revendication 4, dans lequel lesdits dopants dudit premier type de conductivité sont du bore et lesdits dopants dudit second type de conductivité sont du phosphore.

7. Procédé pour former des puits (65, 68, 71) dans un substrat semi-conducteur (60) selon la revendication 1, comprenant les étapes supplémentaires suivantes, lorsqu'une région de puits (68, 71) reste à former:

application d'une couche de résine photosensible (67a, b),

retrait de parties de ladite résine photosensible (67a, b) pour créer ainsi des parties exposées dudit nitrure de silicium (62),

implantation à travers lesdites parties exposées du nitrure de silicium (62) et ladite mince couche d'oxyde (61) de dopants d'un type de conductivité choisi en une concentration choisie dans ledit substrat semi-conducteur (60), pour former ainsi un puits (68, 71) dudit type de conductivité choisi ayant une tension de claquage déterminée par ladite concentration choisie,

diffusion desdits dopants d'un type de conductivité choisi dans ledit substrat semi-conducteur (60), et

retrait de ladite couche de nitrure de silicium (62) et de ladite mince couche d'oxyde (61).

EP 0 182 876 B1

FIG. Ia
(PRIOR ART)

FIG. Ib
(PRIOR ART)

FIG. 2a
(PRIOR ART)

FIG.2b (PRIOR ART)

1

FIG. 3a (PRIOR ART)

FIG. 3b (PRIOR ART)

FIG. 4a (PRIOR ART)

FIG.4b (PRIOR ART)

| 51<br>N WELL | 52<br>P WELL | 53 |
|---|---|---|

P            50

FIG. 5

61      62

60

FIG. 6a

64

63

61
62

60

FIG. 7a

FIG. 7b

FIG. 7 c

FIG. 7 d

FIG. 7 e

69

66

68

65

60

FIG. 7 f

71

69

66

68

65

60

FIG. 7g

72

71

69

68

66

65

60

FIG. 7 h

67a

62
61

68

66

65

67b

60

FIG. 7 i

68    65

60

FIG. 7 j

130    B⁺ IMPLANT    101  102  122  101  130  102  123

121

N WELL    71    High Voltage
Region 68    P WELL    65

60

FIG. 8

101  102  145  121  145  101  147  122  147  101  102  146  123  146  101

P+    P+    High Voltage
Region 68    N+    N+

N WELL    71    P WELL    65

60

FIG. 9

AL-2

PVX-2

121    122    AL-1

123    PVX-1

145  P+  P+  145    147    146  N+  N+  146

N WELL    71    High Voltage
Region 68    P WELL    65

60

FIG. 10